# EUROPEAN PATENT APPLICATION

(11) **EP 4 400 863 A1**
(43) Date of publication of application: **17.07.2024**
(21) Application number: 24151258.1
(22) Date of filing: 10.01.2024
(51) Int. Cl.: G01S 7/481, G01S 7/4863, G01S 17/89

(54) **ANALOG TO DIGITAL CONVERSION MANAGEMENT FOR MULTIPLE RECEIVER CHANNELS IN COHERENT MECHANICAL LIDAR**

(30) Priority: 10.01.2023 US 202363479348 P
(71) Applicant: Luminar Technologies, Inc., Orlando, FL 32826 (US)
(72) Inventor: KLEMME, Daniel Joseph, Robbinsdale (US); MOHR, Daniel Aaron, St. Paul (US)
(74) Representative: Purdylucey Intellectual Property

(57) **Abstract**

A LiDAR system (400) includes a light source (410) to generate light pulses, a mechanical scanner (402), a detector (414) including an array of discrete detector channels to convert light input into electrical signals, a lens (412) that focuses both light pulses generated at the light source onto the mechanical scanner and returning light (432) reflected from the mechanical scanner for reception in sequence by the detector channels, a first analog to digital converter, ADC (454), connected to each of the detector channels in the array and to convert the electrical signals from the detector channels into digital data signals, and a signal processor (456) coupled to the ADC to receive the digital data signals therefrom and to generate images of targets in a field of view of the LiDAR system from the digital data signals. The LiDAR system counteracts the effect of angle offset on detection induced by the rotating scanning mirror. Moreover, the lens transforms the reflection angle offset into a positional offset on the detector face. This positional offset becomes larger as the range to a target increases and cannot be tolerated. A fast-scanning mechanical LiDAR system may use a switch architecture to reduce the required number of ADC channels while overcoming angle lag. For example, if two laser pulses are emitted such that returning light may overlap on the detector due to the angle lag, two pairs of ADC channels may be used to detect returning light on two pairs of adjacent receive channels simultaneously.

## Description

### BACKGROUND

Light detection and ranging (LiDAR) is a technology that measures a distance to an object by projecting a laser toward the object and receiving the reflected laser light. The distance is generally calculated from the time of flight (ToF) of the laser light, i.e., the time between generation of the laser light at the LiDAR device and the time a reflection of the laser light is received at a detector at the LiDAR device. The speed of light is a known value, and the return trip time is easily converted into distance. Multiple light pulses transmitted at different angles, or a dispersed light transmission, can be used to increase accuracy by triangulation calculations based upon light received at different angles at the detector. Scanning LiDAR provides a more accurate representation of a wide field of view (FoV) by moving the laser light beam, or pulses of laser light, rapidly back and forth and up and down over an area, similar to the movement of an electron beam on the cathode-ray tube of original generation television. Unlike television, however, LiDAR systems operate by detecting the reflected light to discern objects in the field of view. Thus, precise capture of the returning light from the LiDAR laser is important to creating an accurate image of objects in the field of view as well as determining their distance from the LiDAR device.

The information included in this Background section of the specification, including any references cited herein and any description or discussion thereof, is included for technical reference purposes only and is not to be regarded subject matter by which the scope of the invention as defined in the claims is to be bound.

### SUMMARY

The technology disclosed herein relates to configurations of transmitter and detector elements in a mechanical LiDAR system to improve detection, as set out in the appended claims. A photonic integrated circuit (PIC) chip is designed using a lithographic process to provide alignment improvement to address scanner-induced angle offset. The PIC chip may be multifunctional: it may route laser light from a light source into local oscillator and transmit components as well as support receiver and detection components. In some example implementations, the PIC chip also modulates the laser light before transmission (e.g., using phase modulation or frequency modulation) in such a way as to better recover range when the light is received as reflected by a target. The returning light may be reflected off the faces of a rotating horizontal scan mirror and routed to one or more free-space couplers and one or more corresponding detectors on the PIC chip. Alignment of receiver and arrangements of connections between the detectors and one or more analog to digital converters compensate for angle lag induced by the rotating scanning mirror and provide trade-offs between cost, power consumption, and signal strength in the LiDAR system.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. A more extensive presentation of features, details, utilities, and advantages of the present invention as defined in the claims is provided in the following written description of various embodiments and implementations and illustrated in the accompanying drawings.

### BRIEF DESCRIPTIONS OF THE DRAWINGS

A further understanding of the nature and advantages of the present technology may be realized by reference to the figures, which are described in the remaining portion of the specification. In the figures, like reference numerals are used throughout several figures to refer to similar components. In some instances, a reference numeral may have an associated sub-label consisting of a lower-case letter to denote one of multiple similar components. When reference is made to a reference numeral without specification of a sub-label, the reference is intended to refer to all such multiple similar components.
FIG. 1 illustrates an example schematic of a mechanical scanning LiDAR system.
FIG. 2 illustrates an alternate view of some of the components of the mechanical scanning LiDAR system of FIG. 1.
FIG. 3 illustrates an effect of a mechanical scanning LiDAR system on reflected light received at the LIDAR system at different times of flight delay due to differing distances traveled.
FIG. 4 illustrates an example design of a PIC chip and corresponding transmission and receiving components in a mechanical scanning LiDAR system.
FIG. 5 schematically illustrates a first example implementation for management of analog to digital converter processing resources for reflected light received at a mechanical scanning LIDAR system.
FIG. 6 schematically illustrates a second example implementation for management of analog to digital converter processing resources for reflected light received at a mechanical scanning LIDAR system.
FIG. 7 schematically illustrates a third example implementation for management of analog to digital converter processing resources for reflected light received at a mechanical scanning LIDAR system.
FIG. 8 schematically illustrates a fourth example implementation for management of analog to digital converter processing resources for reflected light received at a mechanical scanning LIDAR system.
FIG. 9 schematically illustrates a fifth example implementation for management of analog to digital converter processing resources for reflected light received at a mechanical scanning LIDAR system.
FIG. 10 schematically illustrates a sixth example implementation for management of analog to digital converter processing resources for reflected light received at a mechanical scanning LIDAR system.
FIG. 11 illustrates an example computer processing system that may be useful in implementing the described LiDAR technology.

### DETAILED DESCRIPTION

With any LiDAR system it is important to create an accurate image of objects in the field of view as well as to determine their distance from the LiDAR device. The technology disclosed herein relates to increasing precision in the capture of the returning light from a LiDAR light source and, thereby, achieving more accurate ranging and greater image definition. One or more implementations disclosed herein are described in the context of a scanning LiDAR system. However, the implementations disclosed may be generalized to other LiDAR implementations.

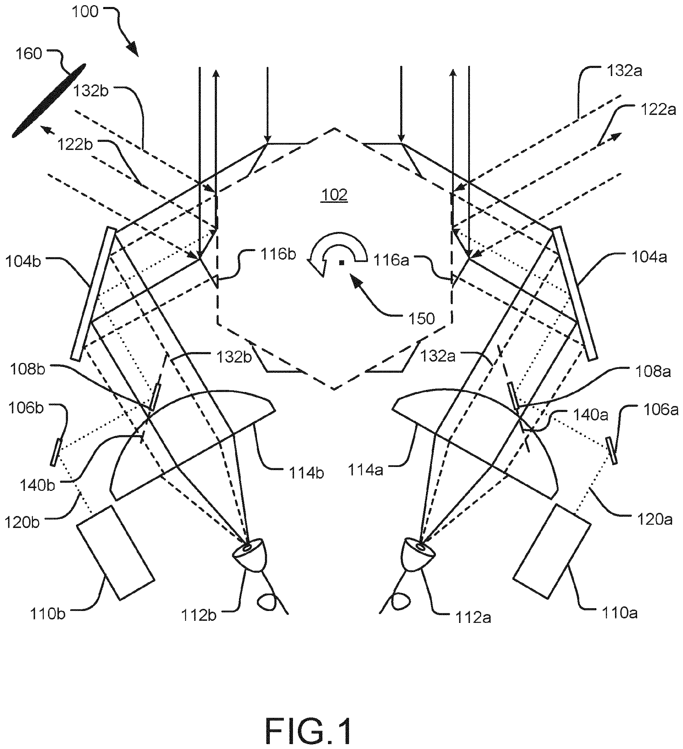

An example mechanically scanning LiDAR device 100, e.g., for automotive applications, is presented schematically in FIG. 1. The mechanically scanning LiDAR device 100 may include of two light sources, e.g., laser sources 110a, 110b, two optical detectors 112a, 112b, two collection lenses 114a, 114b, two vertical scanning mirrors 104a, 104b (also referred to as "galvo mirrors"), and one polygonal, rotating, horizontal scanning mirror 102 with n sides. In FIG. 1, component elements that are configured in substantial symmetry are indicated by "a" and "b" with respect to the corresponding reference numeral. When referring to such symmetric components together in the text, only the reference numeral may be used to refer to both of such symmetric components. Thus, for example, laser sources 110a and 110b may be referred to together as laser sources 110, detectors 112a and 112b may be referred to together as detectors 112, and so on.

In one implementation, each laser source 110 is directed into a respective vertical scan mirror 104 by auxiliary mirrors 106 and 108. The vertical scanning mirrors 104 direct the laser light (either continuous or pulsed) from the laser sources 110 to raster vertically (up and down) across a field of view (FoV) as the vertical scanning mirrors 104 articulate. The vertical scanning mirrors 104 are each mounted on horizontal pivot axes 140 resulting in laser light reflection at positive (upward) or negative (downward) angles from horizontal as the vertical scanning mirrors 104 pivot back and forth on the pivot axes 140. In one example implementation, the vertical scanning mirrors 104 oscillate about horizontal axes at 5 Hz per cycle about ± 7.2° to provide a vertical scan range of about ± 10° or 20° total.

In the embodiment of FIG. 1, the horizontal scanning mirror 102 may be hexagonally shaped and rotate on a vertical axis 150, orthogonal to the axes 140 of the vertical scanning mirrors 104. In alternative implementations, the horizontal scanning mirror 102 may be a 3-, 4-, 5-, or 7- sided polygonal mirror. The horizontal scanning mirror 102 rotates at a very high speed, e.g., hundreds of rotations per second. Each facet 116 of the hexagonal shape of the horizontal scanning mirror 102 successively sweeps the laser pulses from the laser sources 110 horizontally across the field of view as the horizontal scanning mirror 102 rotates. In an embodiment using a hexagonal-shaped horizontal scanning mirror 102, each facet 116 receives the laser light at angles of between 0° and 30° as each facet moves in and out of the laser beam. This translates into a horizontal sweep over the field of view of between 0° and 60° as the horizontal scanning mirror 102 rotates. The angle of reflection also changes as the horizontal scanning mirror 102 rotates, dependent on the angle of the facet 116 at any given instant. Thus, the horizontal scanning mirror 102 effectively scans the light beam 120 horizontally in the plane of the page of FIG. 1, while the vertical scanning mirrors 104 effectively scan the light beam 120 across the field of view vertically in and out of the plane of the page, resulting in a scan in two independent dimensions. Further, due to the configuration with two laser sources 110 and two vertical scanning mirrors 104 reflecting light to opposite facets 116 of the horizontal scanning mirror 102, the LiDAR device 100 effectively doubles the horizontal field of view to about 120°.

In FIG. 1, the light beam 120 reflected from the horizontal scanning mirror 102 is shown as outgoing beam 122. Objects 160 in the field of view which reflect light bounce scattered light back toward the LiDAR device 100. After colliding with an object 160, the returning light 132 in the form of a back-scattered light beam reflects off a facet of the horizontal scanning mirror 102 and is directed toward the vertical scanning mirrors 104 in reverse direction. The returning light 132 reflects off the vertical scanning mirrors 104 toward the collection lenses 114. The collection lenses 114 focus the returning light 132 toward the detectors 112. By relating the time of generation of light at the laser sources 110 to the time of receipt by the detectors 112, the mechanically scanning LiDAR device 100 can estimate the distance of the object in the field of view. Scanning thousands of laser pulses per second at different mirror positions, up and down and back and forth across the field of view, with the addition of range measurement, allows the LiDAR device 100 to map the field of view in the surrounding environment in three dimensions.

It should be understood that the actual implementation of the mechanically scanning LiDAR device 100 need not fit the precise geometric configuration as pictured in FIG. 1. In alternative implementations, the angles and component arrangements may be different than that disclosed in FIG. 1. Further, different or additional scanning components may be used. For example, alternative LiDAR implementations could include two fast-pivoting vertical scan mirrors (galvo mirrors); two rotating horizontal scan mirrors; a rotating horizontal scan mirror and a rotating prism; and other high-speed, rotating or pivoting, reflective structures. Thus, the configuration of FIG. 1 is exemplary and used for purposes of an explanatory environment herein, but other configurations for mechanical scanning in a LiDAR system are contemplated and may be used in conjunction with the detection structures and methods described herein.

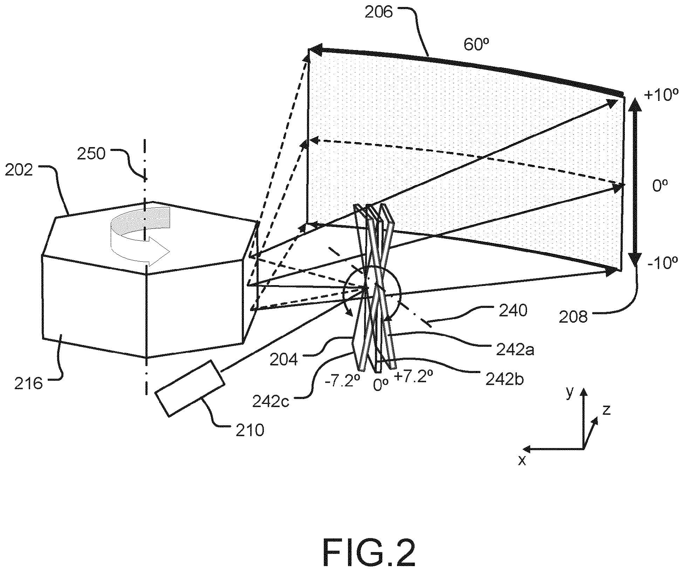

FIG. 2 schematically presents an isometric view of some of the components of a LiDAR device 200 to better depict the scan area and related field of view achieved. As in FIG. 1, the horizontal scan mirror 202 may be hexagonally shaped and rotate on a vertical axis 250. The vertical scan mirror 204 is mounted on a horizontal pivot axis 240 and moves between a vertical position 242a and a positive deflection angle 242b of 7.2° from vertical and a negative deflection angle 242c of -7.2° from vertical. As the vertical scan mirror 204 pivots back and forth on the pivot axis 240, laser light from the laser source 210 is reflected to the facets 216 of the horizontal scan mirror 202 at different heights between ±10° from a middle horizontal. The laser light then reflects off the facets 216 of the horizontal scan mirror 202 into the field of view. The horizontal scan mirror 202 thus provides a horizontal scan range of about 60° and the vertical scan mirror 204 similarly provides a vertical scan range 208 of about 20°.

As mentioned above, systems employing LiDAR sensor devices allow extraction of range information for objects in a field of view by detecting returning light emitted from a known laser source or sources at known times, positions, and orientations and measuring the round-trip delay of the of the returning light. Intensity information of the returning light may also be used to determine range or surface features of objects in the field of view. In a mechanically scanning LiDAR device, such as the mechanically scanning LiDAR device 100 of FIG. 1, the rapidly spinning opto-mechanical scanner, e.g., the horizontal scanning mirror 102, introduces a scanner-induced angle offset to returning light.

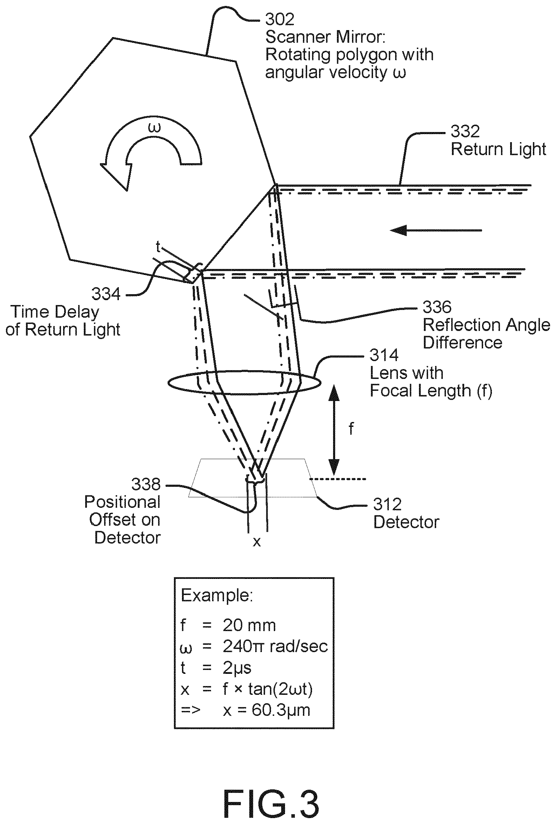

An example of this phenomenon is depicted in FIG. 3 in which the horizontal scan mirror 302 is a polygonal block shape with mirrored surfaces on each sidewall. The horizontal scan mirror 302 spins at an angular velocity ω. It is not feasible to stop or even slow down the horizontal scan mirror 302 while the emitted light pulse is in flight. The momentum of the horizontal scan mirror 302 ensures its motion will continue through a time delay period 334 (often a few microseconds) that an optical pulse is in flight. However, this means that the horizontal scan mirror 302 will be pointing in a slightly different direction when the returning light pulse 332 is received compared to when the light pulse was emitted. Because of this, the horizontal scan mirror 302 will reflect a returning light pulse 332 at a different angle compared to when it was transmitted. Often this reflection angle offset 336 is fractions of a degree, and it increases linearly with distance to the target that a light pulse reflects from. When the returning light pulse 332 is focused by a collection optic such as a lens 314, the lens 314 will focus the returning light pulse 332 onto a detector 312. However, the lens 314 also transforms the reflection angle offset 336 into a positional offset 338 on the detector face. This positional offset 338 becomes larger as the range to a target increases.

The magnitude of this positional offset 338 is usually a few 10's to potentially a few 100's of microns in typical embodiments. For example, as shown in the example of FIG. 3, for a lens 314 with focal length (f) of 20mm, a rotational speed ω of the horizontal scan mirror 302, a total time delay period (t) 334 of the light pulse from targets in the field of view, the positional offset (x) 338 may be calculated by the equation x = f × tan(2ωt). In this example, the positional offset (x) 338 is calculated to be 60.3 µm. Standard, direct-detection LiDAR systems, such as time-of-flight systems, can simply use a detector with a size on the order of the positional offset induced by the scan mirror 302. While this would result in more noise on the detector 312, detection by the overall system remains feasible.

In contrast, in coherent LiDAR systems, optical heterodyne detection is used to extract information from returning light encoded as modulation of the phase, frequency, or both, of the light emitted from the light source. For example, with frequency-modulated continuous wave (FMCW) LiDAR, light from the laser source is frequency shifted to emit linear optical frequency chirps. In another implementation, a pseudo-random binary sequence (PRBS) pattern may be encoded on the phase of the light emitted from the laser source. The returning light pulse is compared with a standard or reference light from a "local oscillator" signal directly from the light source that has a fixed offset in frequency and phase from the returning light pulse. Heterodyne mixing of the returning light pulse with the local oscillator signal light maps the target distance to a frequency or phase of the returning light signal. The optical elements are thus diffraction-limited, which requires highly precise alignment-on the order of a few microns or less-between the transmitter of the light from the light source and the detector. This corresponds to alignment tolerances 0.1 to 0.05 degrees with respect to reflecting transmitted or received light off the rotating scanning mirror. Because coherent LiDAR relies on the precise interference of the local oscillator laser beam with the returning light, the system cannot tolerate positional offset that is much greater than the size of a single mode, which is often on the order of the wavelength of light used, or only a few microns.

Coherent LiDAR provides both range and velocity measurements through the Doppler effect, providing highly sensitive measurements with high dynamic range. Coherent LiDAR systems are often implemented using photonic integrated circuit (PIC) chips to manipulate the light pulses before transmission to achieve different desired transmission profiles. Advantageously, PIC chips for LiDAR are typically designed for operation around wavelengths of 1550 nm, which is beneficial in view of its resistance to sunlight glare and interference and conformance with eye-safety requirements for light sources in some applications, e.g., for automobiles. This relatively longer wavelength, compared to other common LiDAR wavelengths, also allows for more efficient range extension, e.g., of 200 m or more. This additional range results from a combination of the coherent encoding (yielding ~10x signal-to-noise ratio gain) and, because of the greater eye safety at the wavelength, greater available light power output to reach that range without requiring a very large collection aperture.

Some LiDAR systems also include the ability to send multiple laser pulses in flight at a given time (i.e., a later pulse can be emitted while an earlier pulse is still returning and being detected) as this increases the number of point cloud points per second a LiDAR system is able to generate. This can be achieved fairly readily in coherent LiDAR systems because the pulses can be encoded differently to provide differentiation from each other upon return and thereby avoid ambiguity in the returning light as to which of the earlier or later laser pulse is detected. However, when multiple laser pulses are in flight, the returning light will typically fall on different regions of the detector because the angle lag for each will be different based upon time of emission and roundtrip distance to target.

In this disclosure, several configurations and related methods of operation of mechanical LiDAR systems are described which counteract the effect of the angle offset on detection. In one example implementation, spatially separate detection channels (e.g., on a PIC chip) are fabricated in a linear array to capture the returning light as it scans across the face of the PIC chip. Each detector channel must be on the order of the size of a wavelength, i.e., a few microns. Each of these detector channels will route the return light to a separate optical mixer where it mixes with a local oscillator optical channel before routing to a balanced photodiode pair for generation of I and Q electrical signals. In general, the channels can each have their own separate analog-to-digital converter (ADC) for full digitization, or some combination of the electrical signals can be tied together to reduce the number of digitization channels that are required. In another example, the electrical signals can also be summed together (e.g., via a voltage adder) to combine signals and reduce the required number of ADCs. These electrical signals can then be sent to a signal processing apparatus.

In another example implementation, multiple, spatially separate detection channels (e.g., on a PIC chip) may be fabricated to capture the returning light as it scans across the face of the PIC chip. However, each detection channel must be on the order of the size of a wavelength (i.e., a few microns) while the total positional offset could be 10's of microns. This means that 20 or more detection channels may be needed to capture all of the returning light due to the effects of angle lag. Therefore, 20 or more photodiodes may be needed to convert the returning light signals to electrical signals and, further, each of these signals will need to be converted from analog to digital for final signal processing. Digitization of every single one of these signals could result in a large number of components and related additional cost and further require a more powerful, and costly, signal processing chip to perform signal processing on a large number of signals. Additionally, since each detector has some amount of noise on it, simply tying them together electrically will greatly increase the noise floor of the system because each detector's noise will add together while only one or two detectors will have the actual signal on it at a given time.

Thus, in a LiDAR system that enables multiple simultaneous pulses in flight, a fast-scanning mechanical LiDAR system may use a switch architecture to reduce the required number of ADC channels while overcoming angle lag. There are several possible configurations and associated methods of switching architecture through which a reduction in the number of ADCs can be achieved. In a first example embodiment, a pair of ADC channels corresponding to the number of overlapping laser pulses in flight may be used. For example, of two laser pulses are emitted such that returning light may overlap on the detector due to the angle lag, two pairs (four) of ADC channels may be used to detect returning light on two pairs of adjacent receive channels simultaneously based upon a timing sequence. By detecting two adjacent panels at once, a higher probabilty of detecting returning light on the boundary between the two channels is achieved. This configuration can achieve full range performance as compared to a single-pulse system, but doubles the required number of ADC channels because of the dual pulse design.

In a second example embodiment, a single pair of ADCs may be used to process only a single return channel, respectively at different positions along the detector. This embodiment results in an approximately 50% penalty in detected power at times because the returning light signal will not always land perfectly on the detector channel. However, this configuration results in a LiDAR system that has 1/V2 of the maximum range of a single-pulse system, but double the number of points per second recorded, which may be a desirable trade-off for consideration in particular applications. Additionally, such a system could conceivably switch between high resolution/low range and low resolution/high range on the fly while in operation, which could be a useful configuration available to a user.

In a third example embodiment, emission of multiple pulses in flight may be achieved by introducing two or more transceivers (Tx/Rx) channels in the PIC chip architecture of a LiDAR system. In this architecture, a first transmitter, e.g., a free space optical coupler, can fire at a first end of the PIC chip and the PIC chip will begin switching along the receiver channels as normal. When the time associated with the angle lag reflects returning light to the location of the second transceiver channel, generally in the middle of the array of free space couplers, the light source may be timed to fire a second laser pulse with a different encoding so that returning light from the second pulse can be disambiguated from the returning light of the first pulse. The angle lag induced on returning light from each pulse results in returning light from both pulses overlapping on the detector. The switching structure between ADCs may be configured to allow the same set of receiving channels to process returning light from both pulses simultaneously while minimizing the number of ADC's required to digitize the received signal. There may be some level of reduced performance for the returning light from the first pulse at the angle lag distance corresponding to the location of the second transceiver channel on the PIC chip because a transceiver channel is less efficient at collecting light than receiver-only channels as will be explained further herein. However, the received light at each of the transceivers is more than adequate to construct a signal.

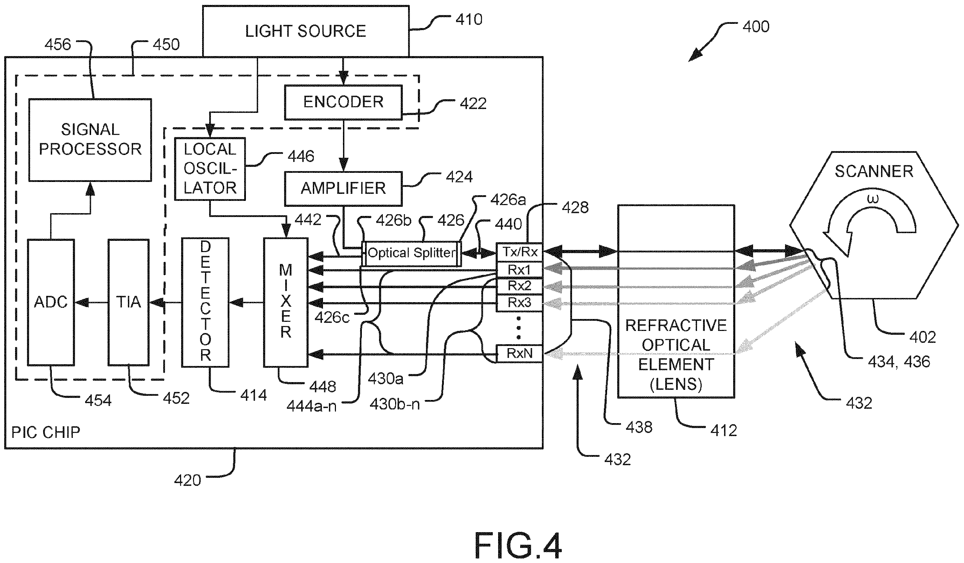

An example embodiment of a mechanical LiDAR system 400 that may be used as the basis for any of these example implementations to counteract negative effects of angle lag is depicted in FIG. 4. Major components of the LiDAR system 400, similar to the system of FIG. 1 include a light source 410 (e.g., a laser), a mechanical scanner such as a rotating scanning mirror 402 (e.g., a polygonal-shaped block with mirrored edges fixed to the shaft of an electric motor), a lens 412 (e.g., a collimator or other refractive optical element), and a detector 414 (e.g., a photodiode, an array of photodiodes in one or more dimensions, or a silicon avalanche photodiode (APD)). Other components may be part of an application-specific integrated circuit (ASIC) 450, or a field-programmable gate array (FPGA) or other signal processing component, mounted on the PIC chip 420. For example, an encoder 422, e.g., to introduce pulses or frequency or phase modulation to the light emitted from the light source 410, may be part of the ASIC 450. An optical amplifier 424 may be fabricated on the PIC chip 420, e.g., by lithographic or other fabrication techniques. A local oscillator 446 may further be fabricated on the PIC chip 420 to siphon a small portion of the light emitted by the light source 410 and output a light signal of a complementary frequency for mixing with the return light 432 in an optical mixer 448, also fabricated on the PIC chip 420, to produce a heterodyne light signal that is passed to the detector 414.

In this embodiment, the detector 414 may also be part of the ASIC 450 mounted on or otherwise fabricated on a portion of a PIC chip 420. The detector 414 may comprise an array of multiple detectors, for example, arranged in parallel, or a single detector unit with an integrated array of photodiode cells. In one implementation, a plurality of photodiode cells may comprise a detector for each of the first free space coupler 428 and the second free space coupler 430a, which may be understood as separate "detection channels." For example, two photodiode cells are needed for In-phase/Quadrature (IQ) detection. In some implementations, four photodiode cells may be used for each individual detection channel to achieve IQ detection on two separate polarization signals in the returning light 432.

One or more transimpedance amplifiers (TIAs) 452 may be connected to the detector 414, e.g., as part of the ASIC 450, to convert current generated by the one or more photodioides of the detector 414 to voltage to create a useable signal outputs. In implementations described above, multiple TIAs 452 may be needed for each detection channel, i.e., one for each photodiode used in a detection channel. One or more analog-to-digital converters (ADCs) 454 may be connected to the TIA(s) 452 on the ASIC 450. The ADCs 454 convert the analog voltage signals from the TIAs 452 representing intensity of returning light 432 received by the photodiodes of the detector 414 to digital signal data that can be processed by a signal processor 456 also mounted on the ASIC 450. The signal processor 456 evaluates the various signal intensities, phases, reflection angles, and other aspects of the returning light 432 to develop a real-time image of objects and their locations within the field of view.

A first free space coupler 428 may be lithographically fabricated on an edge of the PIC chip 420. A second free space coupler 430a may also be lithographically fabricated on the edge of the PIC chip 420 spaced slightly apart from and lithographically aligned with the first free space coupler 328. In other embodiments, the free space couplers 428, 430a may be lithographically fabricated on a face of the PIC chip 420 for transmission and reception out of and into a planar surface of the PIC chip 420. Through lithographic alignment on the PIC chip 420, the fine tolerances of sub-micrometer spacing to account for positional offset 438 on the detector 414, corresponding to the small angular offset 436 of returning light 432 directed to the detector 414 from the rotating scanning mirror 402 due to the time delay 434 of returning light 432 reflecting off targets at different ranges, can be achieved. The spacing distance between the first free space coupler 428 and the second free space coupler 430a may be calculated according to the formula of FIG. 3, i.e., based upon the extent of positional offset 438 of the returning light 432 resulting from angular lag corresponding to rotation of the rotating scanning mirror 402. Recall from the Illustration in FIG. 3 that returning light 432 from a light pulse moves laterally across the detector 414. Depending on the exact time delay 434 that the light experiences in transit, the focal spot on the detector 414 will be at a different position due to the slight angle offset 436 induced by the rotating scanning mirror 402. As noted above with respect to FIG. 3, the positional offset 438 for various increments of time delay 434 (which effectively corresponds to the range to target reflecting the incident light pulse) reflecting off the rotating scanning mirror 402 can be calculated using the time delay 434, the rotational speed of the rotating scanning mirror 402, and the effective focal length of the lens 412.

A transmission waveguide 440 is lithographically fabricated on the PIC chip 420 and is optically coupled at a first end to the light source 410, either directly, or indirectly with one or more intervening components or structures as further described below. A receiver waveguide 444a is also lithographically fabricated in the PIC chip 420 and extends between and is optically coupled at a first end to the second free space coupler 430a and optically coupled at a second end to the detector 414.

In some exemplary embodiments, an optical signal divider, such as an optical splitter 426 or an optical circulator, may also be fabricated on the PIC chip 420. In the embodiment depicted in FIG. 4, the optical signal divider is a 2x1 optical splitter 426 oriented in a reverse configuration. A typical 2x1 optical splitter has a single input and splits the light signal passing through it into two output channels. The percentage of light split between the two output channels may be congruent or different depending upon the design of the optical splitter 426. As noted, in the embodiment shown in FIG. 4, the orientation of the optical splitter 426 is reversed from that of typical implementations. In this implementation, the input port 426a of the optical splitter 426 is optically coupled with the transmission waveguide 440 and thereby to the first free space coupler 428. A first output port 426b of the optical splitter 426 is optically coupled via a waveguide to the light source 410, either directly or with intervening components such as the amplifier 424 and encoder 422. A second output port 426c of the optical splitter 426 is optically coupled to the detector 414 via an output receiver waveguide 442 lithographically fabricated within the PIC chip 420.

Currently there are no acceptable solutions, e.g., devices such as an optical isolator or circulator, available for PIC chips, which would allow transmission of 100% of the light from the light source 410 and then direct 100% of the received returning light 432 to the detector 414. However, if an optical splitter with 50:50 transmission in both transmit and receive directions were used, the output light will only transmit with a 50% efficiency, meaning the overall LiDAR performs half as well as it otherwise could because of the low intensity of the transmitted light. Instead, by using a highly skewed optical splitter 426, e.g., with between 95:5 and 99:1 transmission in both transmit and receive directions, between 95%-99% efficiency in transmission is achieved, so the LiDAR overall performs almost identical to an idealized circulator.

In this configuration, a light pulse generated after light emitted from the light source 410 passes through the encoder 422 and the optical amplifier 424 are received via a waveguide at the first output port 426b of the optical splitter 426. The optical splitter 426 is a passive element and the light pulses are free to travel through it in any direction. Thus, almost all of the light in the light pulses generated by the light source 410 will exit the optical splitter 426 through the input port 426a and travel over the transmission waveguide 440 to the first free space coupler 428 where they exit the PIC chip 420 and travel to the lens 412 and the rotating scanning mirror 402 before exiting the LiDAR system 400. Photons of the light pulses reflecting off of extremely close targets in the field of view will return extremely quickly such that there is very little angular offset 436 caused by the rotating scanning mirror 402. That portion of the returning light 432 thus returns through the lens 412 with almost no positional offset 438 and is aligned with the first free space coupler 428.

In such a situation, the first free space coupler 428 may operate as an optical transceiver (i.e., as both a transmitter and a receiver) and additionally receive a portion of the returning light 432 from the rotating scanning mirror 402. This portion of the returning light 432 travels through the optical splitter 426 in the normal direction such that some of the returning light exits the optical splitter 426 through the first output port 426b and returns to the light source 410 and the remainder exits the optical splitter 426 through the second output port 426c and as ultimately received at the detector 414 via the output receiver waveguide 442. As noted above, depending upon chosen design only 1%-5% of the returning light 432 through the first free space coupler 428 will pass through the optical splitter 426 to reach the detector 414. Understanding, however, that the intensity of the returning light 432 decreases at the inverse of travel distance (double the range (R)) squared (i.e., 1/(2R)²), the intensity of returning light 432 reflected from a short distance (e.g., <15m) most likely to hit the first free space coupler 428 will be 400 times as strong as returning light 432 from a 300m target (per the relationship I₂/I₁=(2R₁)²/(2R₂)²).

The LiDAR system 400 is typically designed to be sensitive to light that travels 400m - 600m round trip. Thus, the detector 414 is sensitive to light intensity at 0.25% of the intensity collected at the first free space coupler 428. When further considering that the optical splitter 426 in line with the first free space coupler 428 will diminish the intensity of the returning light 432 along that path to 1%-5% of the intensity received at the first free space coupler 426, the intensity at the detector 414 is still 4 times the intensity of light returning from a 300 m target, which is plenty for rendering images. Thus, use of the optical splitter 426 in a reverse orientation may come at the cost of lower signal strength from nearby targets due to the beam split of the returning light 432 and being less coherent due to interference with outgoing light pulses. However, the returning light 432 from nearby targets is much less attenuated than returning light 432 from targets near the maximum range, resulting in a net gain in the overall range that can be detected, as long as the decoherence is not overwhelmingly strong.

A plurality of additional free space couplers 430b-n (Rx2-RxN) may also be lithographically fabricated on the PIC chip 420 and optically coupled to a plurality of corresponding detectors 414 (or respective inputs among an array of inputs formed on a single, integrated detector) by a corresponding plurality of additional receiver waveguides 444b-n. As with the second free space coupler 430a, the spacing distance between the first free space coupler 428 and the additional free space couplers 430b-n may be calculated according to the formula of FIG. 3, i.e., based upon the extent of positional offset 438 of the returning light 432 resulting from angular offset 436 corresponding to rotation of the rotating scanning mirror 402. As before, the positional offsets 438 for various increments of time delay 434 reflecting off the rotating scanning mirror 402 can be calculated using the time delay 434, the rotational speed of the rotating scanning mirror 402, and the effective focal length of the lens 412.

The PIC chip 420 is positioned and oriented within the LiDAR system 400 such that the free space couplers 428, 430a-n are located across from the lens 412 (or an intermediate mirror reflecting light from or to the lens 412) to transmit pulsed light to or receive focused or collimated returning light 432 that passes through the lens 412. Through lithographic alignment on the PIC chip 420, the additional free space couplers 430b-n, each of which may be understood as a "detection channel" as described above, may be positioned to coincide with the sub-micrometer positional offset 438 of the returning light 432 resulting from the combination of time-of-flight delay and the angular velocity of the rotating scanning mirror 402. Fabrication of the detector 414 on the PIC chip 420 allows for easy alignment of an array of multiple sensors along the detector 414 corresponding to each of the additional free space couplers 430b-n as compared to tedious mechanical alignment of multiple detectors with the lens and related testing to ensure registration and capture of returning light across the length of the positional offset to ensure capture of all targets at different ranges within the field of view.

With this understanding of the structure and components of the LiDAR system 400 incorporating the self-aligned PIC chip 420 for light detection, the path of a light emitted from either from an internal (i.e., fabricated on the PIC chip 420) or external light source 410 and pulsed can now be easily understood. Light pulses are directed into a waveguide on the PIC chip 420 and sent through the first output port 426b of the optical splitter 426. The light pulse then travels through the input port 426a along the transmission waveguide 440 to the first free space coupler 428. The light pulse leaves the PIC chip 420 from the first free space coupler 428 and passes through a refractive optical element, i.e., the lens 412, which collimates the light pulse into a beam. This collimated light pulse is then routed to the rotating scanning mirror 402, which transmits the light into the field of view.

When the light returns to the LiDAR system after reflecting off of targets within the field of view, the different travel times of portions of the returning light 432 (i.e., delay due to different ranges to targets) cause the rotating scanning mirror 402 to induce a lag or offset angles 436 on the different portions of the returning light 432. The lens 412 collimates and translates the portions of the returning light 432 into different positional offsets 438 along the edge of the PIC chip 420. The array of free space couplers 428, 430a-n function as receivers (Rx1-RxN) for the returning light 432. As the second and additional free space couplers 430a-n are lithographically aligned to the first free space coupler 428, they are able to receive the returning light 432 with high efficiency. The returning light 432 collected at each of these receive-only second and additional free space couplers 430b-n) is routed to one or more detectors 414 either on or off the PIC chip 420.

For very close targets, the lag angle may not be enough to reach the receiver-only second and additional free space couplers 430a-n. In this case, the first free space coupler 428 acts as a transceiver and collects this portion of the returning light 432 and passes it to the optical splitter 426. The optical splitter 426 routes some fraction of that light to the detector 414. Again, the efficiency is generally not a concern because nearby targets will produce much more reflected light than distant targets, so there is generally more than a sufficient amount of signal.
As indicated above, once returning light 432 is received and reaches the detector 414, it needs to be converted into a digital signal for processing by the signal processor 456. However, when using an array of detectors 414 as fabricated on the PIC chip 420, analog-to-digital conversion resources can be difficult to manage. While it is possible to provide one ADC 454 for each photodiode on the detector 414, such can be expensive and also overly taxing on the signal processor 456.

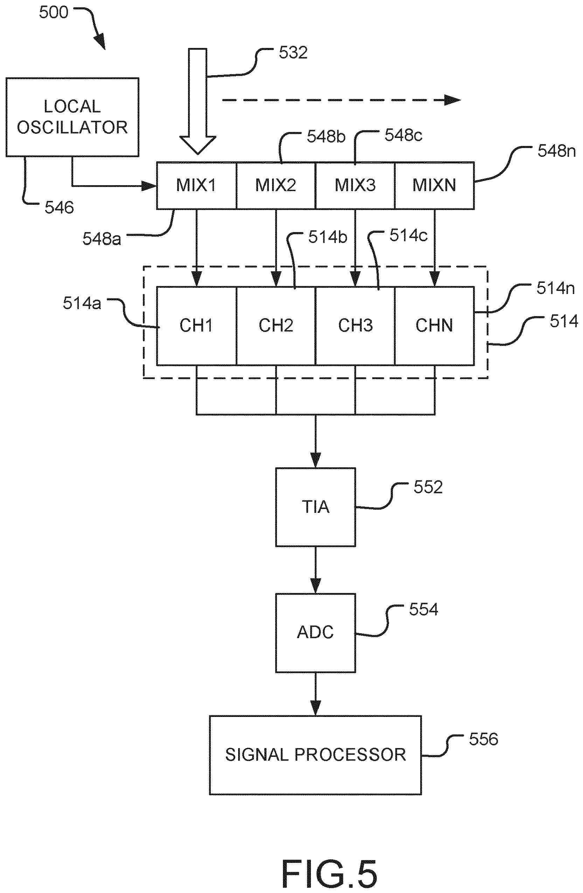

FIG. 5 depicts a first example implementation of a detector circuit 500 of a LiDAR system summarized above in which a detector 514 with spatially separate detection channels 514a-n (e.g., photodiodes on a PIC chip) are fabricated in a one-dimensional or linear array to capture the returning light 532 as it scans across the face of the PIC chip, as indicated by the dashed arrow, due to the angle lag of the rotating scanning mirror. As shown, returning light 532 received from by the array of free space coupler receivers is transmitted to an array of optical mixers 548a-n corresponding to the number of receiver channels and detector channels 514a-n. The returning light 532 received at each optical mixer 548a-n is mixed with a light signal from the local oscillator 546 of a complementary frequency to provide the heterodyne light signals to the respective detector channels 514a-n.

While it is technically possible to provide a separate TIA and ADC for each detector channel 514a-n to digitize each signal, such may be too great a burden for efficient or low cost signal processing and may not be a desirable design. Further, ADCs are expensive and power hungry. Therefore, as shown in the example embodiment of FIG. 5, a single TIA 552 and a single ADC 554 may be provided and connected to each of the detector channels 514a-n. In such a configuration, each signal output from any of the detector channels 514a-n is sent to the same TIA 552 and ADC 554 and then the digital signal created is sent to the signal processor 556 for image determination. This design is very cost efficient and processing efficient and may be suitable for low cost mechanical LiDAR applications to address angle lag.

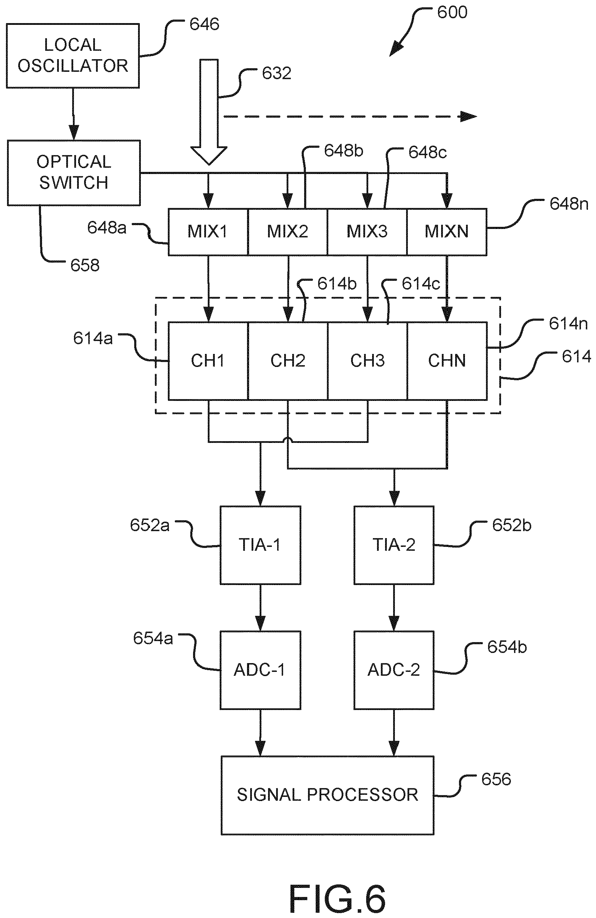

A tradeoff of routing all detector channels through a single ADC is that returning light signals may be received on adjacent channels nearly similtaneously, which may result in signal gain or loss if the adjacent returning light signals detectors are not matched in phase. While signal gain is not typically and issue, signal loss is. In particular, if the signal phases are 180° apart, they will cancel each other out and a target reflecting light pulses at a certain range may not be fully or accurately recognized by the LiDAR system. Thus, a second, alternate example implementation of a detector circuit 600 of a LiDAR system is presened in FIG. 6 to overcome this phase problem.

Similar to the system of FIG. 5, the detector circuit 600 in FIG. 6 includes a detector 614 with spatially separate detector channels 614a-n (e.g., photodiodes on a PIC chip) fabricated in a linear array to capture the returning light 632 as it scans across the face of the PIC chip, as indicated by the dashed arrow, due to the angle lag of the rotating scanning mirror. As shown, returning light 632 received by the array of free space coupler receivers is transmitted to an array of optical mixers 648a-n corresponding to the number of receiver channels and detection channels 614a-n. The returning light 632 received at each optical mixer 648a-n is mixed with a local light signal from the local oscillator 646 of a complementary frequency to provide the heterodyne light signals to the respective detector channels 614a-n. The local light signals from the local oscillator 646 may further be controlled by an optical switch 658 to direct the local light signals discretely to each optical mixer 648a-n in sequence, timed with the expected returning light 632 hitting a respective receiver channel due to the angle lag of the mechanical scanner.

In this embodiment, the detector circuit 600 includes two TIAs 652a/b and two corresponding ADCs 654a/b operating in parallel and connected in an alternating manner to every other one of the detector channels 514a-n, respectively. For example, the first ADC 654a may be connected to all of the odd detector channels 614a, 614c, etc., while the second ADC 654b is connected to all of the even detector channels 614b, 614n, etc. The digital signals output from the ADCs 654a/b are sent to the signal processor 656 for image determination. By providing a separate ADCs 654a/b to manage output from adjacent pairs of the detector channels 654a-n, signal cancellation due to phase differences for overlapping signals is avoided. While this design requires more ADC's, it is still a relatively cost and power efficient configuration to manage signal processing for a large array of detector channels 614a-n in mechanical LiDAR applications to address angle lag.

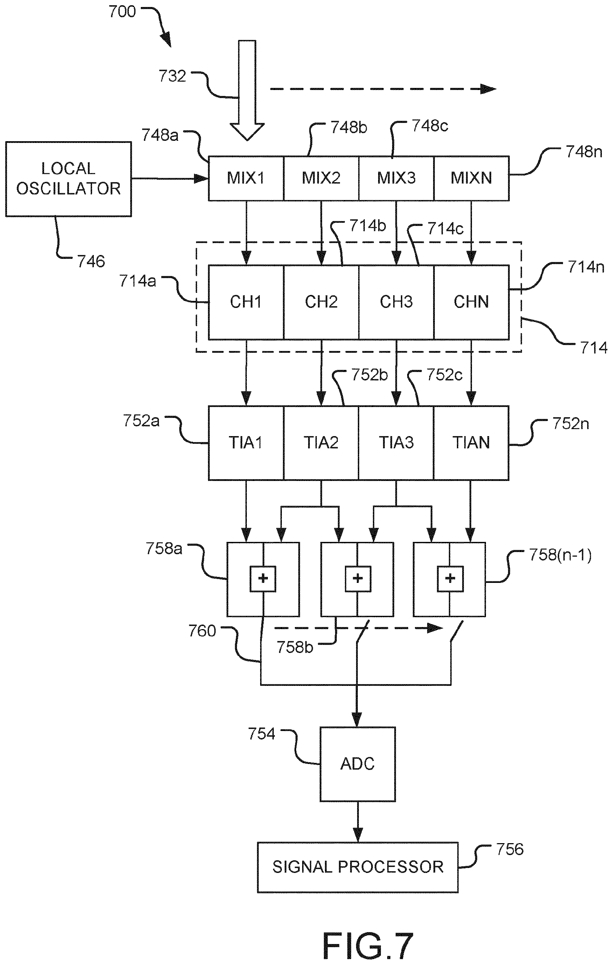

Another example implementation of a detector circuit 700 for use in a mechanical LiDAR system with a multi-channel detector 714 to compensate for angle lag is depicted schematically in FIG. 7. The detector 714 includes a plurality of spatially separate detection channels 714a-n (e.g., photodiodes on a PIC chip) fabricated in a linear array to capture the returning light 732 as it scans across the face of the PIC chip, as indicated by the dashed arrow, due to the angle lag of the rotating scanning mirror. As shown, returning light 732 received from by the array of free space coupler receivers is transmitted to an array of optical mixers 748a-n corresponding to the number of receiver channels and detector channels 714a-n. The returning light 732 received at each optical mixer 748a-n is mixed with a light signal from the local oscillator 746 of a complementary frequency to provide the heterodyne light signals to the respective detector channels 714a-n.

In this implementation, a corresponding array of TIAs 752a-n is provided, with a respective TIA allocated to receive current output from each of the detector channels 714a-n. Further, an array of voltage adders 758a-(n-1) is interposed between the detector channels 714an and a single ADC 754. In this configuration, voltage output from adjacent channels of TIAs 725a-n are sent to corresponding voltage adders 758a-(n-1). For example, voltages from the first and second channels are transmitted to and added in a first voltage adder 758a, voltages from the second and third channels are transmitted to and added in a second voltage adder 758b, and so on. The voltage adders 758a-(n-1) combine the two signals so that when the signal falls in between two spatial channels and is partially on both, the signals add together and can be handled by the same ADC 754. A timed switch array 760 synchronized with the angle lag of the rotating scanning mirror may intermittently and sequentially connect and disconnect each of the voltage adders 758a-(n-1) to the ADC 754 corresponding to the positional receipt of returning light 732 along the detector array. The digital signals output from the ADC 654 is then sent to the signal processor 656 for image determination.

As noted, this configuration of the detector circuit 700 provides the benefit of fully capturing a signal for returning light 732 falls spatially between two channels and is partially received on both channels. Additionally, as only one ADC 754 is used, there are benefits of lower cost and lower power consumption to the design. Further, as output from each of the voltage adders 758a-(n-1) is switched, each output is isolated, preventing introduction of noise from the other channels. However, as with the embodiment of FIG. 5, signals on adjacent channels that are out of phase with each other may still cancel each other out and the returning light 732 hitting those channels may not register a signal at the ADC 754, thus limiting the resolution of the LiDAR system. System designers should appreciate these tradeoffs of cost, power consumption, and response when selecting an appropriate detector circuit for a given application.

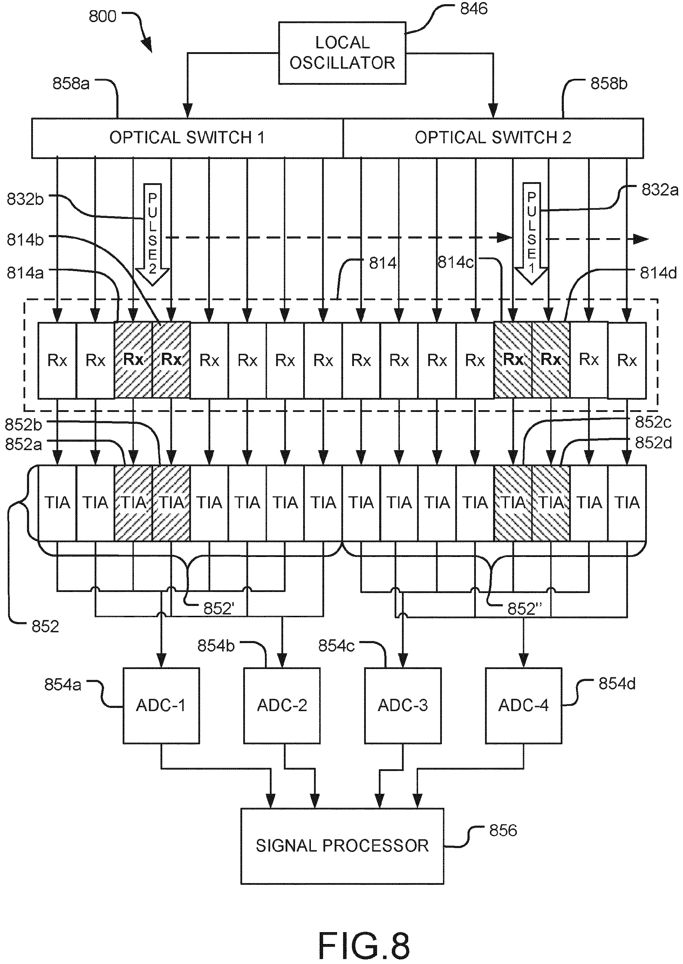

FIG. 8 depicts another example implementation of a detector circuit 800 for a mechanical LiDAR system that sends multiple successive pulses from a light source within a short period such that two or more pulses are in flight during the period. For example, in a configuration in which two pulses in a period, light emitted from a second pulse will begin travel toward targets in the field of view while reflected returning light 832a from a first pulse returns to the detector 814. Further, returning light 832b from the second pulse reflecting off of close targets will be received at a first end of the detector 814 while returning light 832a from the first pulse reflecting off of more distant targets in the field of view is still being received at a second end of the detector 814 due to angle lag effects of the rotating scanning mirror. Thus, returning light from two different emitted pulses may be received at the detector 814 simultaneously. This two-pulse example can be extrapolated to other implementations in which greater than two pulses in a single period are managed by the LiDAR system.

As shown in FIG. 8, the detector 814 is composed of an array of many detector channels (e.g., photodiodes) corresponding to each receiver channel on the PIC chip. The number of receiver and detector channels in the detector 814 (and corresponding TIAs 852 for each detector channel) is a design choice influenced primarily by the angle lag distance and the desired image resolution. The returning light received on each receiver channel is mixed with a local light signal of a complementary frequency from the local oscillator 846. Local light signals from the local oscillator 846 may further be controlled by optical switches 658a/b to direct the local light signals discretely to corresponding optical mixers in sequence, timed with the expected returning light 832 hitting a respective receiver channel due to the angle lag of the mechanical scanner. Note, for the sake of simplicity, the corresponding optical mixers for each channel are not depicted in FIG. 8 but would be present as in the prior embodiments described herein to provide heterodyne mixing of local light signals and the returning light. In the embodiment of FIG. 8, two optical switches 858a/b may be used to better manage two separate groups of signals directed to different ADCs as further described below.

In FIG. 8 two pulses of light are emitted during a single period and the diagram represents a snapshot when reflected light from both emissions has returned and reached the detector 814. Returning light 832a from a first pulse reflected from targets at a more distant range in the field of view may be received at a more distal position on the detector 814 e.g., at detector channels 814c/d. Returning light 832b from a second pulse reflected from targets at a closer range in the field of view may be received at a more proximal position on the detector 814, e.g., at detector channels 814a/b.

As discussed previously, returning light signals may be received on adjacent channels nearly simultaneously as indicated in FIG. 8, which may result in signal gain or loss if the adjacent returning light signals detectors are not matched in phase. While signal gain is not typically and issue, signal loss is. In particular, if the signal phases are 180° apart, they will cancel each other out and a target reflecting light pulses at a certain range may not be fully or accurately recognized by the LiDAR system. Appropriate configuration of ADCs in the detector circuit 800 can ameliorate this problem.

As shown in FIG. 8, the receiver channels exiting the TIAs 852 following the detector 814 are split into two groups, a first half 852' and a second half 852". The first half 852' of the TIAs 852 are connected to a first pair of ADCs 854a/b and the second half 852" of the TIAs 852 are connected to a second pair of ADCs 854c/d. The first pair of ADCs 854a/b operates in parallel, and the ADCs 854a/b are connected in an alternating manner to every other one of the first half 852' of the TIAs 852, respectively. For example, the first ADC 854a may be connected to all of the odd receiver channels, including, e.g., TIA 852a, while the second ADC 854b may be connected to all of the even receiver channels, including, e.g., TIA 852b. The digital signals output from the ADCs 854a/b are sent to the signal processor 856 for image determination. By providing a separate ADCs 854a/b to manage output from adjacent pairs of the receiver channels associated with the first half 852' of the TIAs 852, signal cancellation due to phase differences between overlapping signals is avoided.

Similarly, as noted, the second half 852" of the TIAs 852 are connected to a second pair of ADCs 854c/d. The second pair of ADCs 854a/b operates in parallel, and the ADCs 854c/d are connected in an alternating manner to every other one of the first half 852' of the TIAs 852, respectively. For example, the third ADC 854c may be connected to all of the odd receiver channels in the second half 852", including, e.g., TIA 852c, while the fourth ADC 854d may be connected to all of the even receiver channels, including, e.g., TIA 852d. The digital signals output from the ADCs 854c/bd are sent to the signal processor 856 for image determination. By providing a separate ADCs 854c/d to manage output from adjacent pairs of the receiver channels associated with the second half 852' of the TIAs 852, signal cancellation due to phase differences between overlapping signals is avoided. While this design requires more ADC's, it is still a relatively cost and power efficient configuration to manage signal processing for a large array of detector channels 814 in mechanical LiDAR applications with multiple laser pulse emissions in a common period to address angle lag. Use of two or more pulses with overlapping returning light provides significantly higher resolution and performance than single pulse systems. In addition, because the returning light 832a/b from dual pulses are well-defined in position on the detector 814, i.e., returning light 832a from a first pulse arrives at a first half of the detector 814 when retuning light 832b from the second pulse arrives at a second half of the detector 814, the returning light 832a/b is received at different pairs of ADCs, i.e., ADCs 854c/d and ADCs 854a/b, respectively, the light pulses do not need to be encoded differently as the simple knowledge of which ADC the signal is received from at the signal processor 856 is sufficient to disambiguate the light pulses. Thus, an encoder is not needed in this implementation.

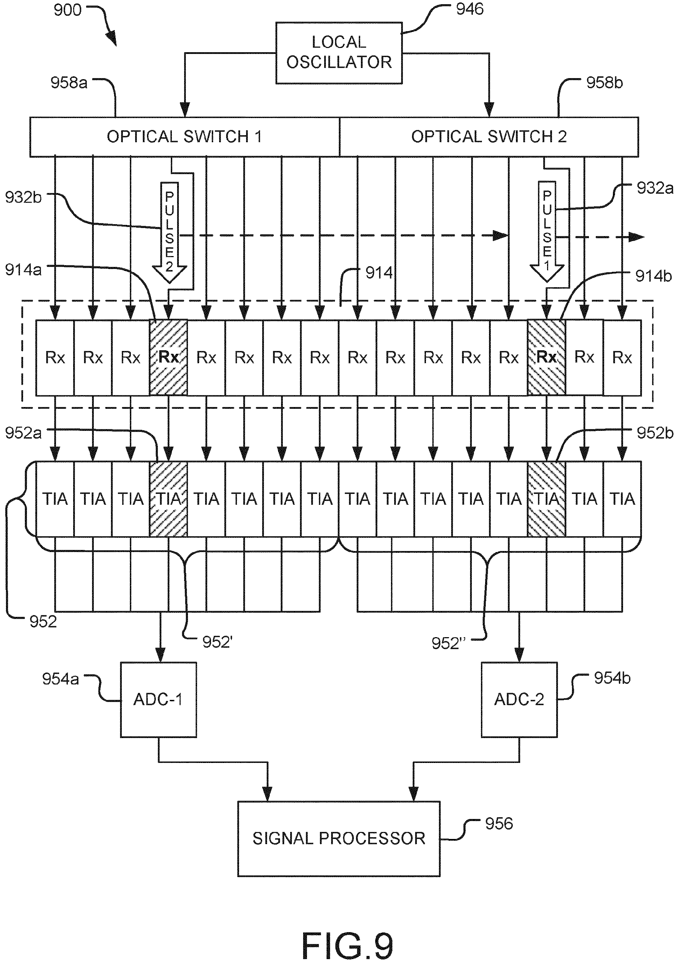

FIG. 9 depicts a further example implementation of a detector circuit 900 for a mechanical LiDAR system that sends multiple successive pulses from a light source within a short period such that two or more pulses are in flight during the period. For example, in a configuration in which two pulses in a period, light emitted from a second pulse will begin travel toward targets in the field of view while reflected returning light 932a from a first pulse returns to the detector 914. Further, returning light 932b from the second pulse reflecting off of close targets will be received at a first end of the detector 914 while returning light 932a from the first pulse reflecting off of more distant targets in the field of view is still being received at a second end of the detector 914 due to angle lag effects of the rotating scanning mirror. Thus, returning light from two different emitted pulses may be received at the detector 914 simultaneously. This two-pulse example can be extrapolated to other implementations in which greater than two pulses in a single period are managed by the LiDAR system.

As shown in FIG. 9, the detector 914 is composed of an array of many detector channels (e.g., photodiodes) corresponding to each receiver channel on the PIC chip. The number of receiver and detector channels in the detector 914 (and corresponding TIAs 952 for each detector channel) is a design choice influenced primarily by the angle lag distance and the desired image resolution. The returning light received on each receiver channel is mixed with a local light signal of a complementary frequency from the local oscillator 946. Local light signals from the local oscillator 946 may further be controlled by optical switches 958a/b to direct the local light signals discretely to corresponding optical mixers in sequence, timed with the expected returning light 932 hitting a respective receiver channel due to the angle lag of the mechanical scanner. Note, for the sake of simplicity, the optical mixers for each channel are not depicted in FIG. 9 but would be present as in the prior embodiments described herein to provide heterodyne mixing of local light signals and the returning light. In the embodiment of FIG. 9, two optical switches 958a/b may be used to better manage two separate groups of signals directed to different ADCs as further described below.

In FIG. 9 two pulses of light are emitted during a single period and the diagram represents a snapshot when reflected light from both emissions has returned and reached the detector 914. Returning light 932a from a first pulse reflected from targets at a more distant range in the field of view may be received at a more distal position on the detector 914 e.g., at receiver channel 914b. Returning light 932b from a second pulse reflected from targets at a closer range in the field of view may be received at a more proximal position on the detector 914, e.g., at receiver channel 914a.

As shown in FIG. 9, the receiver channels exiting the TIAs 952 following the detector 914 are split into two groups, a first half 952' and a second half 952". The first half 952' of the TIAs 952 are connected to a first ADC 954a and the second half 952" of the TIAs 952 are connected to a second ADC 954b. The returning light 932a/b from dual pulses are well-defined in position on the detector 914, i.e., returning light 932a from a first pulse arrives at a first half of the detector 914 when retuning light 932b from the second pulse arrives at a second half of the detector 914, the returning light 932a/b is received at different ADCs, i.e., ADCs 954a/b, respectively. Therefore, the light pulses do not need to be encoded differently as the simple knowledge of which ADC, i.e., ADC 954a or ADC 954b, the signal is received from at the signal processor 856 is sufficient to disambiguate the light pulses. Thus, an encoder is not needed in this implementation.

Use of two or more pulses with overlapping returning light provides significantly higher resolution and performance than single pulse systems, which is a benefit to the system. However, as discussed previously, returning light signals may be received on adjacent channels nearly similtaneously, which may result in signal gain or loss if the adjacent returning light signals detectors are not matched in phase. In particular, if the signal phases are 180° apart, they will cancel each other out and a target reflecting light pulses at a certain range may not be fully or accurately recognized by the LiDAR system. In addition, the range performance for this implementation of FIG. 9 will be reduced relative to the configuration of FIG. 8. In a worst case scenario, the detector circuit 900 may collect only 50% of the power as detector circuit 800, e.g., if the returning light 932a/b lands directly in the middle between two adjacent receiver channels, the best case is that half the light goes to each receiver channel. Further, if the respective ADC 954a/b actively switches between signal inputs from the TIAs 952, only one of the two split signals will be received at a corresponding ADC 954a/b. This circumstance with the design of detector circuit 900 of FIG. 9 translates to roughly 70% of the range of detector circuit 800. On the other hand, the detector circuit 900 of FIG. 9 is is very cost efficient and power efficient due to the lower number of ADCs, while providing increased resolution due to the use of dual pulses in a single period, and may be suitable for lower cost mechanical LiDAR applications to address angle lag.

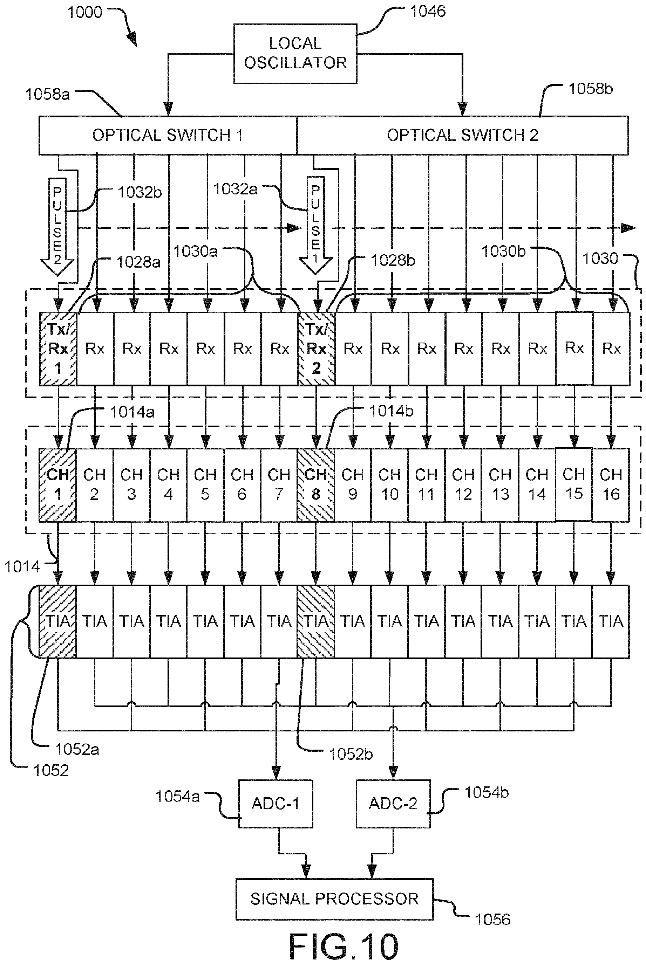

FIG. 10 depicts an example implementation of an emitter/detector circuit 1000 for a mechanical LiDAR system that sends multiple successive pulses from a light source within a short period such that two or more pulses are in flight during the period. For example, in a configuration in which two pulses in a period, light emitted from a second pulse will begin travel toward targets in the field of view while reflected returning light 1032a from a first pulse returns to the detector 1014. Further, returning light 1032b from the second pulse reflecting off of close targets will be received at a first end of the detector 1014 while returning light 1032a from the first pulse reflecting off of more distant targets in the field of view is still being received at a second end of the detector 1014 due to angle lag effects of the rotating scanning mirror. Thus, returning light from two different emitted pulses may be received at the detector 1014 simultaneously. This two-pulse example can be extrapolated to other implementations in which greater than two pulses in a single period are managed by the LiDAR system.

The embodiment of FIG. 10 is also similar to the LiDAR system 400 of FIG. 4 in that it includes transceiver channels formed by respective free space couplers, on the PIC chip. However, by incorporating two transceiver channels, the embodiment of FIG. 10 differs from the embodiment of FIG. 4, which only has one transceiver channel. For ease of reference in this discussion, the free space couplers acting as transceivers will be referred to as the first transceiver 1028a and the second transceiver 1028b, or collectively as the transceivers 1028a/b. The schematic design of FIG. 10 is simplified and does not show the optical splitters for each transceiver channel or the local oscillator and corresponding optical mixers for each channel. However, such would exist in the detector circuit 1000 in a similar manner as shown in FIG. 4.

The emitter/detector circuit 1000 uses the transceivers 1028a/b to send two successive pulses from a light source within a short period such that two pulses are both in flight during the period. For example, light emitted from a second pulse by the second transceiver 1028b will begin travel toward targets in the field of view while reflected returning light 1032a from a first pulse previously emitted by the first transceiver 1028a returns to the emitter/detector circuit 1000. Further, returning light 1032b from the second pulse reflecting off of close targets will be received at a first end of the emitter/detector circuit 1000 while returning light 1032a from the first pulse reflecting off of more distant targets in the field of view is still being received at a second end of the emitter/detector circuit 1000 due to angle lag effects of the rotating scanning mirror. Thus, returning light from two different emitted pulses may be received at the emitter/detector circuit 1000 simultaneously. This two-pulse example can be extrapolated to other implementations in which greater than two pulses in a single period are managed by the LiDAR system.

As shown in FIG. 10 (in the context of FIG. 4), an array of free space couplers 1030 is positioned on an edge of a PIC chip. The free space coupler at a first position functions as the first transceiver 1028a. Another free space coupler at a second position in the array, separated from the first transceiver 1028a by several free space couplers, functions as the second transceiver 1028b. In one embodiment, the second transceiver 1028b may be positioned midway within the array of the free space couplers 1030. In an alternative embodiment, the second transceiver 1028b may be positioned at a timed delay location from the first transceiver 1028a corresponding to the incidence of returning light 1032a from a first pulse at such time. For example, the second transceiver 1028b may be positioned 1 µs away from the first transceiver 1028a as measured by the location that returning light 1032a emitted by the first transceiver 1028a hits the array of free space couplers 1030 after 1 µs due to the angle lag of the rotating scanning mirror. A first set of free space couplers 1030a, which act only as receivers, extends between the first transceiver 1028a and the second transceiver 1028b, and a second set of free space couplers 1030b, which also act only as receivers, extends distally from the second transceiver 1028b to the end of the array of free space couplers 1030 on the PIC chip.

The detector 1014 is composed of an array of many detector channels (e.g., photodiodes) corresponding to each of the free space couplers 1030 in the PIC chip. The number of free space couplers 1030 and detector channels in the detector 1014 (and corresponding TIAs 1052 for each detector channel) is a design choice influenced primarily by the angle lag distance and the desired image resolution. The returning light received at each of the free space couplers 1030 is mixed with a local light signal of a complementary frequency from the local oscillator 1046. Local light signals from the local oscillator 1046 may further be controlled by optical switches 1058a/b to direct the local light signals discretely to corresponding optical mixers in sequence, timed with the expected returning light 1032 hitting a respective one of the free space couplers 1030 due to the angle lag of the mechanical scanner. Note, for the sake of simplicity, the corresponding optical mixers for each detector channel are not depicted in FIG. 10 but would be present as in the prior embodiments described herein to provide heterodyne mixing of local light signals and the returning light. In the embodiment of FIG. 10, two optical switches 1058a/b may be used to better manage two separate groups of signals received from different groups of the free space couplers 1030, each group including a respective transceiver as further described below.

In FIG. 10 two pulses of light are emitted during a single period and the diagram represents a snapshot when reflected light from both emissions has returned and reached the detector 1014. Returning light 1032a from a first pulse emitted by the first transceiver 1028a and reflected from targets at a more distant range in the field of view may be received at a more distal position, in this example case, at the location of the second transceiver 1028b. Returning light 832b from a second pulse emitted by the second transceiver 1028b and reflected from targets at a closer range in the field of view may be received at a more proximal position, in this example case, at the location of the second transceiver 1028b.

Returning light received at any of the free space couplers 1030 is transmitted to corresponding detector channels (e.g., photodiodes) on the detector 1014 (after mixing with light from a local oscillator in a corresponding optical mixer). For example, returning light 1032b received at the first transceiver 1028a is transmitted to a first detector channel 1014a and returning light 1032a received at the second transceiver 1028b is transmitted to an eighth detector channel 1014b aligned with and corresponding to the second transceiver 1028b. An array of TIAs 1053 is aligned with the detector channels is positioned between the detector 1014 and the ADCs 1054a/b. For example, a signal transmitted from the first detector channel 1014a is received at and converted by a first TIA 1052a and a signal emitted from the eighth detector channel 1014b is received at and converted by an eighth TIA 1052b in the array of TIAs 1052.

As discussed previously, returning light signals may be received on adjacent channels nearly similtaneously, which may result in signal gain or loss if the adjacent returning light signals detectors are not matched in phase. In particular, if the signal phases are 180° apart, they will cancel each other out and a target reflecting light pulses at a certain range may not be fully or accurately recognized by the LiDAR system. Appropriate configuration of ADCs in the emitter/detector circuit 1000 can ameliorate this problem.

As shown in FIG. 10, the receiver channels exiting the TIAs 1052 following the detector 1014 are arranged in two groups, each group connected to a respective one of the ADCs 1054a/b. The pair of ADCs 1054a/b operates in parallel, and the ADCs 1054a/b are connected in an alternating manner to every other one of the TIAs 1052, respectively. For example, the first ADC 1054a may be connected to all of the odd receiver channels, including, e.g., TIA 1052a, while the second ADC 1054b may be connected to all of the even receiver channels, including, e.g., TIA 1052b. The digital signals output from the ADCs 1054a/b are sent to the signal processor 1056 for image determination. By providing a separate ADCs 1054a/b to manage output from adjacent pairs of the receiver channels output from the TIAs 1052, signal cancellation due to phase differences between overlapping signals is avoided. Further, input to the ADCs 1054a/b may be controlled by time switching synchronized with the computed angle lag to accept returning light when focused on specific receiver locations in each of the first set of free space couplers 1030a and the second set of free space couplers 1030b.

While this design uses two ADC's, it is still a relatively cost and power efficient configuration to manage signal processing for a large array of detector channels 1014 in mechanical LiDAR applications with multiple laser pulse emissions in a common period to address angle lag. Use of two or more pulses with overlapping returning light provides significantly higher resolution and performance than single pulse systems. However, there is a signal-to-noise loss in the detected signals due to returning light of two pulse emissions overlapping each other on the detector channels. By encoding the light pulses emitted from the first transceiver 1028a differently than an encoding of light pulses emitted from the second transceiver 1028b, the returning light 1032a/b from dual pulses can be disambiguated, e.g., by frequency or phase differences, by the signal processor 1056.

As described previously with respect to FIG. 4, due to the use of an optical splitter on channels including the transceivers 1028a/b, those channels are less efficient at collecting light than receiver-only channels (i.e., the first and second sets of free space couplers 1030a/b). While there should not be a significant impact to measurement of returning light 1032b received at the first transceiver 1028a as explained previously with respect to FIG. 4, there will be a more pronounced impact on the signal from returning light 1032a received at the second transceiver 1028b. At this location, the returning light 1032 is reflected from targets at a further distance, and thus the power of the returning light 1032 received at the second transceiver is much lower than the power of the returning light 1032b received at the first transceiver 1028a and the further pass-through limitation by the optical splitter will additionally denigrate the ultimate signal generated. However, the returning light 1032a at the second transceiver 1028b is not reflected from targets at the maximum range of the LiDAR system, so highly reflective targets will likely be adequately imaged, but targets with low reflectivity at such a medium range location may not be adequately detected.

In one implementation, the LiDAR system disclosed herein includes a light source configured to emit light; a mechanical scanner configured to move rapidly about an axis; a detector including an array of discrete detector channels configured to convert light input into electrical signals; a lens that focuses both light emitted at the light source onto the mechanical scanner and returning light reflected from the mechanical scanner for reception in sequence by the detector channels; a first analog to digital converter (ADC) connected to a first subset of the detector channels in the array and configured to convert the electrical signals from the first subset of the detector channels into digital data signals; a second ADC positioned in parallel with the first ADC, connected to a second subset of the detector channels in the array, and configured to convert the electrical signals from the second subset of the detector channels into digital data signals; and a signal processor coupled to both the first ADC and the second ADC to receive the digital data signals therefrom and configured to generate images of targets in a field of view of the LiDAR system from the digital data signals.

In another implementation, the LiDAR system includes a third ADC positioned in parallel with the first ADC and the second ADC, connected to a third subset of the detector channels in the array, and configured to convert the electrical signals from the third subset of the detector channels into digital data signals; and a fourth ADC positioned in parallel with the first ADC, the second ADC, and the third ADC, connected to a fourth subset of the detector channels in the array, and configured to convert the electrical signals from the fourth subset of the detector channels into digital data signals; and wherein the signal processor is further coupled to the third ADC and the fourth ADC to receive the digital data signals therefrom and configured to generate images of targets in a field of view of the LiDAR system from the digital data signals.

In one implementation of the LiDAR system the first subset of the detector channels and the third subset of the detector channels together comprise a first series of adjacent detector channels within a first contiguous portion of the array of discrete detector channels, the second subset of the detector channels and the fourth subset of the detector channels together comprise a second series of adjacent detector channels within a second contiguous portion of the array of discrete detector channels, the first subset of the detector channels comprises an alternating series of the odd positioned detector channels in the first series of adjacent detector channels; the third subset of the detector channels comprises an alternating series of the even-positioned detector channels in the first series of adjacent detector channels; the second subset of the detector channels comprises an alternating series of the odd positioned detector channels in the second series of adjacent detector channels; and the fourth subset of the detector channels comprises an alternating series of the even-positioned detector channels in the second series of adjacent detector channels.

In one implementation of the LiDAR system the encoder is configured to emit two light pulses within a period such that light emitted as a second light pulse begins travel toward targets in a field of view of the LiDAR system while returning light from a prior emitted first light pulse reflected by targets in the field of view is received at the detector; wherein returning light from the second light pulse reflected by close targets in the field of view is received within the first series of the detector channels during the period while returning light from the first light pulse reflected by more distant targets in the field of view is received within the second series of the detector channels during the period due to angle lag effects of the mechanical scanner.

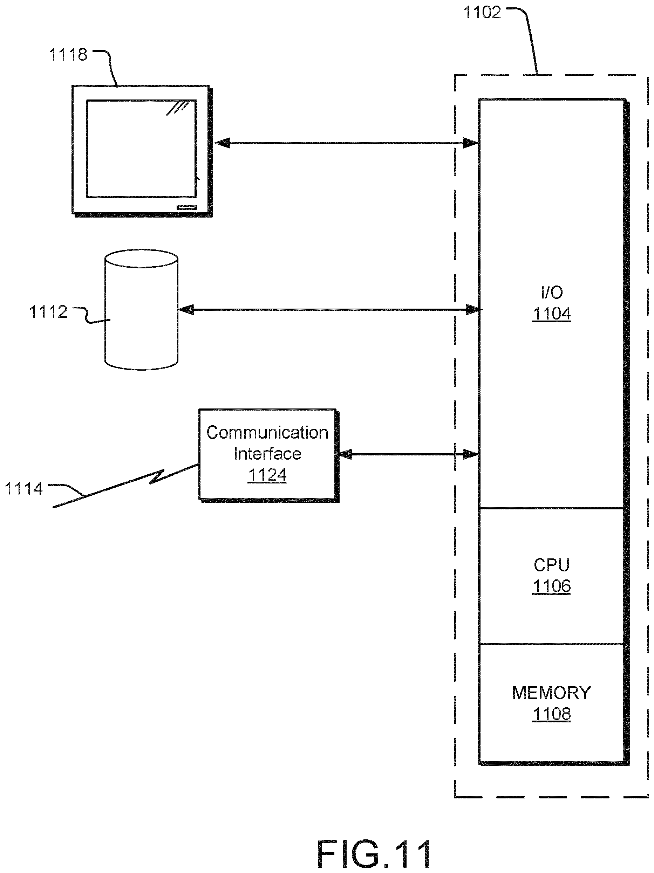

FIG. 11 illustrates an example computer processing system 1100 that may be useful in implementing the described technology. The computer processing system 1100 may be implemented in a device attached to the LiDAR device, such as a user device, storage device, internet of things (IoT) device, a desktop computer, a laptop computer, a processing system integrated into device or a vehicle in which the LiDAR is mounted, e.g., a security camera, an automobile, a drone, etc. The computer processing system 1100 is capable of executing a computer program product embodied in a tangible computer-readable storage medium to execute a computer process. Data and program files may be input to the computer processing system 1100, which reads the files and executes the programs therein using one or more processors 1102 (e.g., central processing units, reduced instruction set computers (RISC)). Some of the elements of an example processing system 1100 are shown in FIG. 11 wherein a processor 1102 is shown having an input/output (I/O) section 1104, a central processing unit (CPU) 1106, and a local memory section 1108.

The processor 1102 of the computer processing system 1100 may comprise a single central-processing unit 1106 or a plurality of processing units. The processing unit(s) 1106 may be single core or multi-core processors. The computer processing system 1100 may be a conventional computer, a distributed computer, or any other type of computer. The described technology is optionally implemented in software loaded in local memory 1108 (e.g., random access memory (RAM) or read only memory (ROM)), a memory hardware device 1112 (e.g., a hard disk drive, an optical memory drive, Flash memory, etc.), and/or communicated via a wired or wireless network link 1114 on a carrier signal (e.g., over Ethernet, a wireless local area network (LAN) protocols, Long Term Evolution(LTE) or 3/4/5G wireless, etc.) thereby transforming the computer processing system 1100 in FIG. 11 into a special purpose machine for implementing the described operations.

The I/O interface 1104 may be connected to one or more user-interface devices (e.g., a keyboard, a touch-screen display unit 1118, etc.) or the memory hardware device 1112. Computer program products containing mechanisms to effectuate the systems and methods in accordance with the described technology may reside in the local memory 1108 or on the memory hardware device 1112 of such a computer processing system 1100.

A communication interface 1124 is capable of connecting the computer processing system 1100 to an enterprise network via the network link 1114, through which the computer system can receive instructions and data embodied in a carrier wave. When used in a LAN environment, the computer processing system 1100 may be connected by wired connection (e.g., Ethernet) or wirelessly (e.g., through a wireless access point or router using 902.11 protocols) to a local network through the communication interface 1124. When used in a wide-area-network (WAN) environment, the computer processing system 1100 typically includes a modem, a network adapter, or any other type of communications device for establishing communications over the WAN. In a networked environment, program modules depicted relative to the computer processing system 1100 or portions thereof, may be stored in a remote memory storage device. It is appreciated that the network connections shown are examples of communications devices for and other means of establishing a communications link between computers may be used.

In an example implementation, a user interface software module, the communication interface 1124, the input/output interface 1104, and other modules may be implemented or embodied by instructions stored in memory 1108 and/or the memory hardware device 1112 and executed by the processor 1102. Further, local computing systems, remote data sources and/or services, and other associated logic represent firmware, hardware, and/or software, which may be configured to assist in supporting a distributed ledger. In addition, keys, device information, identification, configurations, etc. may be stored in the memory 1108 and/or the memory hardware device 1112 and executed by the processor 1102.

Data storage and/or memory may be embodied by various types of processor-readable storage media, such as hard disc media, a storage array containing multiple storage devices, optical media, solid-state drive technology, ROM, RAM, and other technology. The operations may be implemented processor-executable instructions in firmware, software, hardwired circuitry, gate array technology and other technologies, whether executed or assisted by a microprocessor, a microprocessor core, a microcontroller, special purpose circuitry, or other processing technologies. It should be understood that a write controller, a storage controller, data write circuitry, data read and recovery circuitry, a sorting module, and other functional modules of a data storage system may include or work in concert with a processor for processing processor-readable instructions for performing a system-implemented process.

For purposes of this description and meaning of the claims, the term "memory" means a tangible data storage device, including non-volatile memories (such as flash memory and the like) and volatile memories (such as dynamic random-access memory and the like). The computer instructions either permanently or temporarily reside in the memory, along with other information such as data, virtual mappings, operating systems, applications, and the like that are accessed by a computer processor to perform the desired functionality. The term "memory" expressly does not include a transitory medium such as a carrier signal, but the computer instructions can be transferred to the memory wirelessly.

In contrast to tangible computer-readable storage media, intangible computer-readable communication signals may embody computer readable instructions, data structures, program modules or other data resident in a modulated data signal, such as a carrier wave or other signal transport mechanism. The term "modulated data signal" means a signal that has one or more of its characteristics set or changed in such a manner as to encode information in the signal. By way of example, and not limitation, intangible communication signals include wired media such as a wired network or direct- wired connection, and wireless media such as acoustic, RF, infrared and other wireless media.

The embodiments of the invention described herein are implemented as logical steps in one or more computer systems. The logical operations of the present invention may be implemented (1) as a sequence of processor-implemented steps executing in one or more computer systems or (2) as interconnected machine or circuit modules within one or more computer systems. The implementation is a matter of choice, dependent on the performance requirements of the computer system implementing the invention. Accordingly, the logical operations making up the embodiments of the invention described herein are referred to variously as operations, steps, objects, or modules. Furthermore, it should be understood that logical operations may be performed in any order, unless explicitly claimed otherwise or a specific order is inherently necessitated by the claim language.

While this specification contains many specific implementation details, these should not be construed as limitations on the scope of any technologies or of what may be claimed, but rather as descriptions of features specific to particular implementations of the particular described technology. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

All directional references (e.g., proximal, distal, upper, lower, upward, downward, left, right, lateral, longitudinal, front, back, top, bottom, above, below, vertical, horizontal, radial, axial, clockwise, and counterclockwise) are only used for identification purposes to aid the reader's understanding of the structures disclosed herein and do not create limitations, particularly as to the position, orientation, or use of such structures. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other. The exemplary drawings are for purposes of illustration only, and the dimensions, positions, order, and relative sizes reflected in the drawings attached hereto may vary.

The above specification, examples, and data provide a thorough description of the structure and use of exemplary embodiments of the invention as defined in the claims. Although various embodiments of the claimed invention have been described above with a certain degree of particularity or with reference to one or more individual embodiments, other embodiments using different combinations of elements and structures disclosed herein are contemplated, as other iterations can be determined through ordinary skill based upon the teachings of the present disclosure. It is intended that all matter contained in the above description and shown in the accompanying drawings shall be interpreted as illustrative only of particular embodiments and not limiting. Changes in detail or structure may be made without departing from the basic elements of the invention as defined in the following claims.

## Claims

1. A LiDAR system comprising
a mechanical scanner configured to move rapidly about an axis;
a detector including an array of discrete detector channels configured to convert light input into electrical signals;
a lens configured to focus both light generated at a light source onto the mechanical scanner and returning light reflected from the mechanical scanner for reception in sequence by the detector channels;
an analog to digital converter (ADC) connected to each of the detector channels in the array and configured to convert the electrical signals from the detector channels into digital data signals; and
a signal processor coupled to the ADC to receive the digital data signals therefrom and configured to generate images of targets in a field of view of the LiDAR system from the digital data signals.

2. The LiDAR system of claim 1 further comprising a transimpedance amplifier interposed between and connected to each of the detector channels and the ADC to amplify a voltage of the electrical signals from the detector channels before input into the ADC.

3. The LiDAR system of claim 1 further comprising a plurality of transimpedance amplifiers corresponding to and connected respectively to each of the detector channels, and interposed between the detector channels and the ADC to amplify a voltage of the electrical signals from the detector channels before input into the ADC.

4. The LiDAR system of any preceding claim further comprising
a plurality of voltage adders interposed between and connected between the plurality of transimpedance amplifiers and the ADC, wherein
a number of the voltage adders is one less than a number of the transimpedance amplifiers;
connection between the voltage adders and the transimpedance amplifiers is arranged such that an output of each adjacent pair of the transimpedance amplifiers is an input to a respective one of the voltage adders; and
outputs from each of the voltage adders are transmitted to the ADC.

5. The LiDAR system of any preceding claim further comprising
a local oscillator that receives a portion of the light emitted by the light source and produces a complementary frequency local light output; and
an optical mixer that receives input of both the returning light from the lens before reception by the detector channels and the local light output from the local oscillator, mixes the returning light with the local light output from the local oscillator to create a heterodyne light signal, and transmits the heterodyne light signal to the detector channels.

6. The LiDAR system of claim 5 further comprising an optical switch interposed between the local oscillator and the optical mixer that is synchronized with an angle lag of the mechanical scanner to direct the local light output to one or more of the detector channels discretely and in sequence corresponding in time to returning light directed to respective ones of the detector channels in sequence by the mechanical scanner.

7. A LiDAR system comprising
a light source configured to emit light;
a mechanical scanner configured to move rapidly about an axis;
a detector including an array of discrete detector channels configured to convert light input into electrical signals;
a lens that focuses both light emitted at the light source onto the mechanical scanner and returning light reflected from the mechanical scanner for reception in sequence by the detector channels;
a first analog to digital converter (ADC) connected to a first subset of the detector channels in the array and configured to convert the electrical signals from the first subset of the detector channels into digital data signals;
a second ADC positioned in parallel with the first ADC, connected to a second subset of the detector channels in the array, and configured to convert the electrical signals from the second subset of the detector channels into digital data signals; and
a signal processor coupled to both the first ADC and the second ADC to receive the digital data signals therefrom and configured to generate images of targets in a field of view of the LiDAR system from the digital data signals.

8. The LiDAR system of claim 7, wherein
the first subset of the detector channels comprises a first series of adjacent detector channels within a first contiguous portion of the array of discrete detector channels; and
the second subset of the detector channels comprises a second series of adjacent detector channels within a second contiguous portion of the array of discrete detector channels.

9. The LiDAR system of claim 7 or 8 further comprising a plurality of transimpedance amplifiers corresponding to and connected respectively to each of the detector channels, arranged in corresponding subsets to the first subset and the second subset of the detector channels, and interposed between the detector channels and the first ADC and second ADC to amplify a voltage of the electrical signals from the detector channels before input into the first ADC and the second ADC.

10. The LiDAR system of any of claims 7 to 9 further comprising
a local oscillator that receives a portion of the light emitted by the light source and produces a complementary frequency local light output; and
an optical mixer that receives input of both the returning light from the lens before reception by the detector channels and the local light output from the local oscillator, mixes the returning light with the local light output from the local oscillator to create a heterodyne light signal, and transmits the heterodyne light signal to the detector channels.

11. The LiDAR system of claim 10 further comprising an optical switch interposed between the local oscillator and the optical mixer that is synchronized with an angle lag effect of the mechanical scanner to direct the local light output to one or more of the detector channels discretely and in sequence corresponding in time to returning light directed to respective ones of the detector channels in sequence by the mechanical scanner.

12. The LiDAR system of claim 7 further comprising
an encoder configured to transform the emitted light into light pulses, wherein
the light source is configured to emit two light pulses within a period such that light emitted as a second light pulse begins travel toward targets in a field of view of the LiDAR system while returning light from a prior emitted first light pulse reflected by targets in the field of view is received at the detector; and
returning light from the second light pulse reflected by close targets in the field of view is received within the first subset of the detector channels during the period while returning light from the first light pulse reflected by more distant targets in the field of view is received within the second subset of the detector channels during the period due to angle lag effects of the mechanical scanner.

13. The LiDAR system of claim 12, wherein the signal processor is further configured to disambiguate returning light emitted as the first light pulse from returning light emitted as the second light pulse based, at least in part, upon whether the returning light is received within the first subset of the detector channels and converted by the first ADC and whether the returning light is received within the second subset of the detector channels and converted by the second ADC.

14. The LiDAR system of any of claims 7 to 13, wherein
the encoder is further configured to impart frequency or phase characteristics to the two light pulses such that the frequency or phase characteristics of the first light pulse differ from the frequency or phase characteristics of the second light pulse; and
the signal processor is further configured to disambiguate returning light emitted as the first light pulse from returning light emitted by the second light pulse based, at least in part, upon the differences in frequency or phase characteristics between the first light pulse and the second light pulse;
and/or wherein the first subset of the detector channels and the second subset of the detector channels are configured with respect to each other to prevent phase cancellation between light input in adjacent detector channels in the array of discrete detector channels.

15. The LiDAR system of any of claims 7 to 14, wherein
the first subset of the detector channels comprises an alternating series of the odd positioned detector channels in the array of discrete detector channels; and
the second subset of the detector channels comprises an alternating series of the even-positioned detector channels in the array of discrete detector channels.

16. The LiDAR system of claim 15, wherein
a first portion of the detector channels comprises a first sequential series of the detector channels in the array of the discrete detector channels;
a second portion of the detector channels comprises a second sequential series of the detector channels in the array of the discrete detector channels;
the encoder is configured to emit two light pulses within a period such that light emitted as a second light pulse begins travel toward targets in a field of view of the LiDAR system while returning light from a prior emitted first light pulse reflected by targets in the field of view is received at the detector; and
returning light from the second light pulse reflected by close targets in the field of view is received within the first portion of the detector channels during the period while returning light from the first light pulse reflected by more distant targets in the field of view is received within the second portion of the detector channels during the period due to angle lag effects of the mechanical scanner;
and/or further comprising a plurality of free space couplers corresponding respectively to each of the detector channels in the array and interposed between the lens and the detector to receive the focused returning light from the lens in sequence and transmit the received returning light sequentially to respective detector channels in the array.

17. The LiDAR system of claim 16, wherein
one of the free space couplers corresponding to one of the detector channels in the first portion of the detector channels is configured as a first transceiver;
one of the free space couplers corresponding to one of the detector channels in the second portion of the detector channels is configured as a second transceiver;
the first transceiver is configured to receive the first light pulse from the encoder and emit the first light pulse to the lens; and
the second transceiver is configured to receive the second light pulse from the encoder and emit the second light pulse to the lens;
and/ optionally wherein a position of the second transceiver is determined by translation of a time delay between emission by the light source of the first light pulse and the second light pulse, such that a location of returning light from the first light pulse on one of the free space couplers at time of emission of the second light pulse corresponding to angle lag of the mechanical scanner is the position of the second transceiver.
